# EUROPÄISCHE PATENTSCHRIFT

(11) **EP 3 420 626 B1**
(45) Veröffentlichungstag und Bekanntmachung des Hinweises auf die Patenterteilung: **29.01.2020**
(21) Anmeldenummer: 17709375.4
(22) Anmeldetag: 21.02.2017
(51) Int. Cl.: G01R 19/165, G01R 31/396, B60L 58/12, B60L 58/22, H02J 7/00

(54) **BATTERIESYSTEM MIT EINER SPANNUNGSAUSGLEICHSSCHALTUNG, VERFAHREN ZUM ERKENNEN EINES FEHLERHAFTEN ZUSTANDES DER SPANNUNGSAUSGLEICHSSCHALTUNG UND DER ZELLSPANNUNGSMESSUNG**
BATTERY SYSTEM WITH A VOLTAGE EQUALISING CIRCUIT, AND METHOD FOR IDENTIFYING A DEFECTIVE STATE OF THE VOLTAGE EQUALISING CIRCUIT AND CELL VOLTAGE MEASUREMENT
SYSTÈME DE BATTERIES AVEC UN CIRCUIT DE COMPENSATION DE TENSION, PROCÉDÉ DE DÉTECTION D'UN ÉTAT DÉFECTUEUX DU CIRCUIT DE COMPENSATION DE TENSION ET MESURE DE TENSION DE CELLULE

(30) Priorität: 23.02.2016 DE 102016202761
(43) Veröffentlichungstag der Anmeldung: 02.01.2019
(73) Patentinhaber: Vitesco Technologies GmbH, 30165 Hannover (DE)
(72) Erfinder: JASTER, Magnus, 14774 Kirchmöser (DE)
(74) Vertreter: Waldmann, Georg Alexander
(86) Internationale Anmeldenummer: PCT/EP2017/053950
(87) Internationale Veröffentlichungsnummer: WO 2017/144473

(56) Entgegenhaltungen:
- EP-A1- 2 595 275
- EP-A1- 2 632 021
- US-A1- 2012 293 128
- US-B1- 8 598 846

## Beschreibung

### Technisches Gebiet:

Die Erfindung betrifft ein Batteriesystem mit einer Spannungsausgleichsschaltung zur Bereitstellung elektrischer Energie, insbesondere für ein Hybridelektro-/Elektrofahrzeug, sowie eine elektrische Antriebsanordnung mit einem genannten Batteriesystem, insbesondere zum Antrieb eines Hybridelektro-/Elektrofahrzeugs.

### Stand der Technik:

Batteriesysteme, insbesondere Traktionsbatterien für Hybridelektro-/Elektrofahrzeuge, umfassen in der Regel eine oder mehrere in Reihe geschalteten Batteriezellen (bzw. Batteriezellblöcke). Die Batteriezellen dürfen nur in bestimmten Spannungsgrenzen betrieben werden, da sie sonst deutlich schneller altern oder sogar eine thermische Reaktion herbeiführen. Diese thermische Reaktion, z.B. in Form eines Brandes, gilt es zu vermeiden.

Bedingt durch unterschiedliche Fertigungstoleranzen und unterschiedliche Alterungen weisen die einzelnen Batteriezellen zudem Schwankungen in ihren Ladekapazitäten und Innenwiderständen auf. Aufgrund der Reihenschaltung führen die unterschiedlichen Ladekapazitäten und die unterschiedlichen Innenwiderstände wiederum dazu, dass die Batteriezellen unterschiedlich auf- und entladen werden und in extremen Fällen kritische Ladezustände (bspw. durch Überladung) einnehmen können.

Die Patentoffenlegungsschrift EP 2 595 275 A1 beschreibt eine Batterievorrichtung mit einer Anzahl von Batteriezellen, einer Spannungsausgleichsschaltung für die Batteriezellen sowie einer Messschaltung zum Messen einer Spannung an einer Batteriezelle.

Die Patentoffenlegungsschrift EP 2 632 021 A1 beschreibt ein Batteriesystem mit einer Vielzahl von Batterien, einer Entladeschaltung.

Damit besteht die Aufgabe der vorliegenden Erfindung darin, eine Möglichkeit bereitzustellen, ein sicheres Batteriesystem kostengünstig herzustellen und sicher zu betreiben.

### Beschreibung der Erfindung:

Diese Aufgabe wird durch Gegenstände der unabhängigen Ansprüche gelöst. Vorteilhafte Ausgestaltungen sind Gegenstand der Unteransprüche.

Gemäß einem ersten Aspekt der Erfindung wird ein Batteriesystem, insbesondere für ein Hybridelektro-/Elektrofahrzeug, bereitgestellt.

Das Batteriesystem umfasst eine oder mindestens zwei in Reihe geschaltete Batteriezellen (bzw. Batteriezellblöcken) sowie mindestens eine Spannungsausgleichsschaltung, welche eingerichtet ist, die Spannung an der einen oder an einer der mindestens zwei in Reihe geschalteten Batteriezellen auszugleichen. Die Spannungsausgleichsschaltung umfasst einen Ausgleichsstrompfad und eine Messanordnung. Dabei ist der Ausgleichsstrompfad zwischen einem positiven Stromanschluss und einem negativen Stromanschluss der einen oder der einen der mindestens zwei Batteriezellen elektrisch angeschlossen. Der Ausgleichsstrompfad umfasst mindestens zwei Widerstände und einen steuerbaren Ausgleichsschalter. Dabei sind die mindestens zwei Widerstände und der Ausgleichsschalter in dem Ausgleichsstrompfad zueinander in Reihe geschaltet. Die Messanordnung ist signaleingangsseitig an einem elektrischen Verbindungspunkt zwischen den beiden Widerständen elektrisch angeschlossen und eingerichtet, ein erstes Spannungspotential an dem elektrischen Verbindungspunkt zu erfassen.

Dabei umfasst die Messanordnung einen Analog-Digital-Wandler, der über einen ersten Signaleingang mit dem elektrischen Verbindungspunkt elektrisch verbunden ist und eingerichtet ist, aus dem ersten Spannungspotential einen ersten digitalen Spannungspotentialwert zu bilden.

Die Messanordnung umfasst ferner einen Filter, der zwischen dem elektrischen Verbindungspunkt und dem Analog-Digital-Wandler elektrisch angeschlossen ist und eingerichtet ist, Wechselpotentialanteile in dem ersten Spannungspotential zu filtern bzw. zu unterdrücken.

Die Messanordnung umfasst ferner einen steuerbaren Überbrückungsschalter, der zwischen dem elektrischen Verbindungspunkt und dem Analog-Digital-Wandler und parallel zu dem Filter elektrisch angeschlossen ist und eingerichtet ist, in einem geschlossenen Schaltzustand den elektrischen Verbindungspunkt mit dem Analog-Digital-Wandler elektrisch kurzzuschließen und somit den Filter zu überbrücken.

Durch den Einsatz von zwei zueinander in Reihe geschalteten Widerständen als Zellspannungsausgleichswiderstände (auf Englisch "Balancing Resistor") anstatt nur einem Widerstand entsteht in dem (Ladungs-)Ausgleichsstrompfad zwischen den beiden Stromanschlüssen der zu balancierenden Batteriezelle ein weiterer Messpunkt (also der Verbindungspunkt zwischen den mindestens zwei Widerständen), an dem ein Spannungspotential (bzw. eine Spannung) präzise messbar ist. Dabei ist das gemessene Spannungspotential bezogen auf das Spannungspotential an dem negativen Stromanschluss der zu balancierenden Batteriezelle gleich hoch wie die Zellspannung und ist somit abhängig von dem Ladezustand dieser Batteriezelle, wenn der steuerbare Ausgleichsschalter geöffnet ist. Ist der Ausgleichsschalter geschlossen und der Vorgang der Zellspannungsausgleichung ("Battery Balancing") eingeleitet, so ist das gemessene Spannungspotential niedriger als die Zellspannung aufgrund der Spannungsteilung durch die in Reihe geschalteten Widerstände.

Weicht das an dem Verbindungpunkt gemessene Spannungspotential von einem vorgegebenen Sollwertbereich ab, so wird durch Schließen des Ausgleichsschalters eine Zellspannungsausgleichung eingeleitet. Ist die Zellspannungsausgleichung durch Schließen des Ausgleichsschalters eingeleitet, so wird das Spannungspotential bzw. die Spannung an dem Verbindungpunkt niedriger sein als die Zellspannung der zu balancierenden Batteriezelle. Während der Zellspannungsausgleichung wird das Spannungspotential an dem Verbindungpunkt weiter gemessen. Nach einer bestimmten Zeit wird durch Öffnen des Ausgleichsschalters die Zellspannungsausgleichung unterbrochen. Ist die Zellspannungsausgleichung unterbrochen, so fließt durch den Ausgleichsstrompfad kein Strom und das Spannungspotential bzw. die Spannung entspricht wieder der Zellspannung der entsprechenden Batteriezelle.

Der Erfindung liegt der Gedanke zugrunde, dass die Batteriezellen (bzw. Batteriezellblöcke) eines Batteriesystems, insb. einer Traktionsbatterie eines Hybridelektro-/Elektrofahrzeugs, nur in bestimmten Spannungsgrenzen betrieben werden dürfen, da sie sonst deutlich schneller altern oder sogar eine thermische Reaktion, z.B. in Form eines Brandes, herbeiführen können. Diese thermische Reaktion gilt es zu vermeiden. Hierzu muss das Abschalten des Batteriesystems bei Über- oder Unterspannung nach hohen Sicherheitsmaßstäben entwickelt werden. Um dies zu gewährleisten, könnte eine redundante Zellspannungsmessung durchgeführt werden, um Einfachfehler zu vermeiden, da mögliche Fehler von der Zellanbindung bis zur Auswertung nicht in Gänze durch eine Diagnosefunktion erkannt werden können.

Bedingt durch unterschiedliche Fertigungstoleranzen und unterschiedliche Alterungen weisen die einzelnen Batteriezellen zudem Schwankungen in ihren Ladekapazitäten und Innenwiderständen auf. Aufgrund der Reihenschaltung führen die unterschiedlichen Ladekapazitäten und die unterschiedlichen Innenwiderstände wiederum dazu, dass die Batteriezellen unterschiedlich auf- und entladen werden und in extremen Fällen kritische Ladezustände (bspw. durch Überladung) einnehmen können. Um kritische Ladezustände bei den Batteriezellen zu vermeiden, müssen an den einzelnen Batteriezellen die jeweiligen aktuellen Ladespannungen sicher gemessen und bei Bedarf deren Ladezustände ausgeglichen werden ("Battery Balancing").

Hierbei sollten die zuvor beschriebenen beiden Funktionen in einer Funktionseinheit zusammengeführt werden, um Bauraum und Herstellungskosten bei dem Batteriesystem zu reduzieren.

Basierend auf diesem Gedanken ist das Batteriesystem mit mindestens einer Spannungsausgleichsschaltung bereitgestellt, welche einen Ausgleichsstrompfad zum Zellspannungsausgleich und eine Messanordnung umfasst, wobei die Messanordnung zur sicheren Spannungsmessung der Zellspannungen und somit zum sicheren Zellspannungsausgleich dient.

Damit ist ein Batteriesystem mit einer sicheren Spannungsmessung durch die Kombination mit einer Spannungsausgleichsschaltung bereitgestellt, das dank der doppelten Funktionen, nämlich der sicheren Spannungsmessung der Zellspannungen und dem sicheren Zellspannungsausgleich, der Messanordnung kostengünstig herstellbar ist und zudem auch sicher betreibbar ist.

Vorzugsweise ist die Messanordnung signaleingangsseitig ferner mit dem negativen Stromanschluss der einen oder der einen der mindestens zwei Batteriezellen elektrisch verbunden und ferner eingerichtet, ein zweites Spannungspotential an dem negativen Stromanschluss zu erfassen.

Der Analog-Digital-Wandler ist vorzugsweise über einen zweiten Signaleingang mit dem negativen Stromanschluss der einen oder der einen der mindestens zwei Batteriezellen elektrisch verbunden und ferner eingerichtet, aus dem zweiten Spannungs-potential einen zweiten digitalen Spannungspotentialwert zu bilden und aus dem ersten und dem zweiten digitalen Spannungspotentialwert die Messspannung auszubilden.

Vorzugsweise umfasst das Batteriesystem ferner eine Steueranordnung, welche der Messanordnung nachgeschaltet ist und eingerichtet ist, den Ausgleichsschalter zu schließen, dadurch die Zellspannungsausgleichung einzuleiten und somit einen geänderten Erwartungswert der Zellspannung zu erzeugen.

Gemäß einem weiteren Aspekt der Erfindung wird eine elektrische Antriebsanordnung, insbesondere zum Antrieb eines Hybridelektro-/Elektrofahrzeugs, bereitgestellt.

Die elektrische Antriebsanordnung umfasst eine elektrische Maschine zum elektrischen Antrieb, insbesondere des Hybridelektro-/Elektrofahrzeugs, sowie eine Leistungsendstufe zum Betreiben der elektrischen Maschine.

Die elektrische Antriebsanordnung umfasst ferner ein zuvor beschriebenes Batteriesystem zum Bereitstellen elektrischer Energie für die elektrische Maschine. Dabei ist das Batteriesystem über elektrische Anschlüsse mit der Leistungsendstufe und ferner über die Leistungsendstufe mit der elektrischen Maschine elektrisch verbunden.

Vorteilhafte Ausgestaltungen des oben beschriebenen Batteriesystems sind, soweit möglich auf die oben genannte elektrische Antriebsanordnung übertragbar, auch als vorteilhafte Ausgestaltungen der elektrischen Antriebsanordnung anzusehen.

### Kurze Beschreibung der Zeichnung:

Im Folgenden werden beispielhafte Ausführungsformen der Erfindung Bezug nehmend auf die beiliegenden Zeichnungen näher erläutert. Dabei zeigen:
- Figur 1: in einer schematischen Darstellung eine elektrische Antriebsanordnung mit einem Batteriesystem mit einer Spannungsausgleichsschaltung gemäß einer Ausführungsform der Erfindung; und
- Figur 2: in einem schematischen Ablaufdiagramm ein Verfahren zum Erkennen eines fehlerhaften Zustandes der Spannungsmessschaltung, insb. der Messanordnung der Spannungsmessschaltung, des in Figur 1 dargestellten Batteriesystems.

### Detaillierte Beschreibung der Zeichnung:

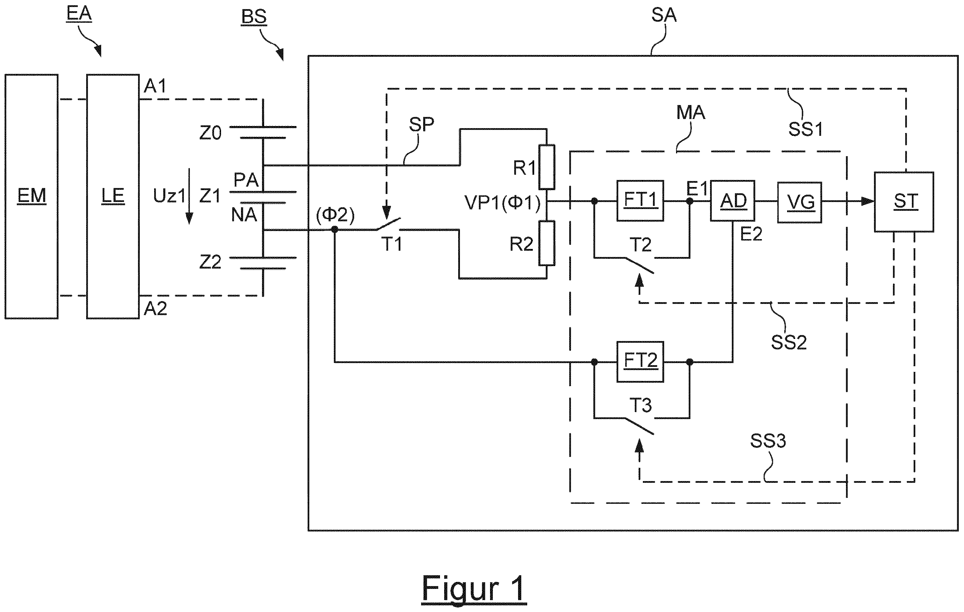

Figur 1 zeigt eine elektrische Antriebsanordnung EA zum Antrieb eines Elektrofahrzeugs in einer schematischen Schaltungstopologie.

Die elektrische Antriebsanordnung EA umfasst eine elektrische Maschine EM zum Antrieb des Elektrofahrzeugs, eine Leistungsendstufe LE zum Betreiben der elektrischen Maschine EM, sowie ein Batteriesystem BS, das als eine Traktionsbatterie elektrische Energie für die elektrische Maschine EM bereitstellt.

Das Batteriesystem BS ist über zwei elektrische Anschlüsse A1, A2 mit der Leistungsendstufe LE und weiter über die Leistungsendstufe LE mit der elektrischen Maschine EM elektrisch verbunden.

Das Batteriesystem BS umfasst eine Anzahl von Batteriezellen Z0, Z1, Z2, die zwischen den elektrischen Anschlüssen A1, A2 in Reihe geschaltet sind.

Das Batteriesystem BS umfasst ferner eine Spannungsausgleichsschaltung SA, die ihrerseits einen Ausgleichsstrompfad SP umfasst, über den die Spannungsausgleichsschaltung SA mit einem positiven Stromanschluss PA und einem negativen Stromanschluss NA einer der Batteriezellen Z0, Z1, Z2 elektrisch verbunden ist.

Die Spannungsausgleichsschaltung SA kann weitere Ausgleichsstrompfade umfassen, welche mit positiven und negativen Stromanschlüssen der jeweiligen anderen Batteriezellen Z0, Z2 elektrisch verbunden sind. Diese Ausgleichsstrompfade werden zur Vermeidung überflüssiger Wiederholungen bei der Figurenbeschreibung nicht beschrieben, funktionieren jedoch analog wie der oben genannte und nachfolgend detailliert zu beschreibende Ausgleichsstrompfad SP.

Der Ausgleichsstrompfad SP umfasst zwei elektrische Widerstände R1, R2 und einen steuerbaren Ausgleichsschalter T1, wobei die zwei Widerstände R1, R2 und der Ausgleichsschalter T1 in dem Ausgleichsstrompfad SP zueinander in Reihe geschaltet sind.

Die Spannungsausgleichsschaltung SA umfasst ferner eine Messanordnung MA, welche ihrerseits einen Analog-Digital-Wandler AD, einen ersten und/oder einen zweiten Filter FT1, FT2, sowie (optional) einen ersten und/oder einen zweiten steuerbaren Überbrückungsschalter T2, T3 umfasst.

Der Analog-Digital-Wandler AD weist einen ersten und einen zweiten Signaleingang E1, E2 auf und ist über den ersten Signaleingang E1 mit dem Verbindungspunkt VP und über den zweiten Signaleingang E2 mit dem negativen Stromanschluss NA elektrisch verbunden.

Der Analog-Digital-Wandler AD ist eingerichtet, ein erstes Spannungspotential an dem Verbindungspunkt VP und ein zweites Spannungspotential an dem negativen Stromanschluss NA zu erfassen und aus den beiden Spannungspotentialen eine analoge Potentialdifferenz zu bilden und diese analoge Potentialdifferenz in eine digitale Messspannung umzuwandeln.

Der erste Filter FT1 ist zwischen dem Verbindungspunkt VP und dem ersten Signaleingang E1 des Analog-Digital-Wandlers AD elektrisch angeschlossen. Der erste Filter FT1 ist als ein Tiefpassfilter ausgebildet und eingerichtet, Potentialschwankungen bei dem ersten Spannungspotential zu unterdrücken um eine Signalunterabtastung zu vermeiden.

Der erste Überbrückungsschalter T2 ist ebenfalls zwischen dem Verbindungspunkt VP und dem ersten Signaleingang E1 des Analog-Digital-Wandlers AD und somit parallel zu dem ersten Filter FT1 elektrisch angeschlossen und eingerichtet, in einem geschlossenen Schaltzustand den Verbindungspunkt VP mit dem ersten Signaleingang E1 elektrisch kurzzuschließen und somit den ersten Filter FT1 zu überbrücken.

Der zweite Filter FT2 ist zwischen dem negativen Stromanschluss NA und dem zweiten Signaleingang E2 des Analog-Digital-Wandlers AD elektrisch angeschlossen. Der zweite Filter FT2 ist ebenfalls als ein Tiefpassfilter ausgebildet und eingerichtet, Potentialschwankungen bei dem zweiten Spannungspotential unterdrücken um eine Signalunterabtastung zu vermeiden.

Der zweite Überbrückungsschalter T3 ist ebenfalls zwischen dem negativen Stromanschluss NA und dem zweiten Signaleingang E2 des Analog-Digital-Wandlers AD und somit parallel zu dem zweiten Filter FT2 elektrisch angeschlossen und eingerichtet, in einem geschlossenen Schaltzustand den negativen Stromanschluss NA mit dem zweiten Signaleingang E2 elektrisch kurzzuschließen und somit den zweiten Filter FT2 zu überbrücken.

Die Spannungsausgleichsschaltung SA umfasst ferner eine Steueranordnung ST zum Ansteuern des Ausgleichsschalters T1 und der beiden Überbrückungsschalter T2, T3. Die Steueranordnung ST umfasst z.B. einen Signaleingang und drei Signalausgänge. Über den Signaleingang ist die Steueranordnung ST mit einem Signalausgang des Analog-Digital-Wandlers AD elektrisch verbunden. Über jeweils einen der Signalausgänge ist die Steueranordnung ST jeweils mit dem Steueranschluss des Ausgleichsschalters T1 und den Steueranschlüssen der beiden Überbrückungsschalter T2, T3 elektrisch verbunden. Ferner können der Überbrückungsschalter T2 und/oder T3 auch direkt von der Spannung über den Widerstand R1 oder R2 gesteuert werden.

Nachdem die Schaltungstopologie des Batteriesystems BS anhand Figur 1 detailliert beschrieben wurde, wird nachfolgend die Funktionsweise des Batteriesystems BS, insb. der Spannungsausgleichsschaltung SA näher beschrieben:
Zum Ausgleichen der Zellspannung an den Batteriezellen Z0, Z1, Z2 misst die Messanordnung MA das Spannungspotential Φ1 an dem Verbindungspunkt VP und das Spannungspotential Φ2 an dem negativen Stromanschluss NA. Die beiden Filter FT1, FT2 unterdrücken dabei die "hochfrequenten" Potentialschwankungen bei den gemessenen Spannungspotentialen Φ1, Φ2. Dabei werden Grenzfrequenzen bei den beiden Filtern FT1, FT2 derart festgelegt, dass die "hochfrequenten" Potentialschwankungen mit einer Frequenz über die gesetzten Grenzfrequenzen verringert werden, aber gleichzeitig die zu berücksichtigen Toleranzen der Zellspannungsmessung nicht wesentlich erhöhen auf Grund der Schwankungen beim Schließen und Öffnen des Ausgleichsschalters T1.

Aus den gefilterten Spannungspotentialen Φ1, Φ2 bildet der Analog-Digital-Wandler AD zunächst eine Potentialdifferenz als eine analoge Messspannung und in einer anschließenden Abtastung eine digitale Messspannung und leitet diese digitale Messspannung an die nachgeschaltete Vergleichseinheit VG.

Die Vergleichseinheit VG vergleicht die digitale Messspannung mit einer vorgegebenen Referenzspannung. Überschreitet die Messspannung die Referenzspannung, so wird ein Signal an die Steueranordnung ST ausgebeben, die daraufhin ein Steuersignal SS1 generiert und mit dem den Ausgleichsschalter T1 angesteuert schließt. Durch den geschlossenen Ausgleichsschalter T1 bildet ein geschlossener Stromkreis durch den Ausgleichsstrompfad SP, durch den sich die Batteriezelle Z1 entlädt und die Zellspannung an der Batteriezelle Z1 reduziert und somit ausgeglichen wird.

Während des Entladevorgangs wird der Ladezustand der Batteriezelle Z1 durch Weitermessen des Spannungspotentials Φ1 an dem ersten Verbindungspunkt VP1 weiter erfasst und daraus die digitale Messspannung gebildet.

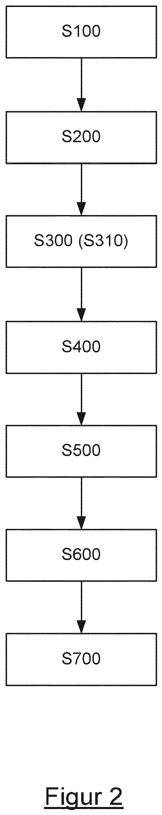

Die Überwachung der Funktionsfähigkeit bzw. die Erkennung eines fehlerhaften Zustandes der Spannungsausgleichsschaltung SA, insb. der Messanordnung MA, erfolgt wie nachfolgend beschrieben, was auch in Figur 2 veranschaulicht ist:
Zum Erkennen eines fehlerhaften Zustandes der Spannungsausgleichsschaltung SA, insb. der Messanordnung MA, öffnet die Steueranordnung ST gemäß einem Verfahrensschritt S100 durch Ändern des Signalpegels des Steuersignals SS1 den Ausgleichsschalters T1, falls dieser geschlossen ist.

Während sich der Ausgleichsschalter T1 in dem offenen Schaltzustand befindet, erfasst die Messanordnung MA gemäß einem weiteren Verfahrensschritt S200 und in der oben beschriebenen Weise an der Batteriezelle Z1 eine erste digitale Messspannung Um1.

Nachdem die erste Messspannung Um1 erfasst wurde, schließt die Steueranordnung ST in einem weiteren Verfahrensschritt S300 durch Ändern des Signalpegels des Steuersignals SS1 den Ausgleichsschalter T1.

Zugleich schließt die Steueranordnung ST gemäß einem weiteren Verfahrensschritt S310 mittels weiteren Steuersignalen SS2, SS3 die Überbrückungsschalter T2 und/oder T3. Ferner können die beiden Überbrückungsschalter T2 und T3 durch das Schließen von dem Ausgleichsschalter T1 mit geschlossen werden durch die Spannungsänderung über einem der beiden Widerstände R1 und R2.

Während sich der Ausgleichsschalter T1 wahlweise mit dem Überbrückungsschalter T2 und/oder T3 in dem geschlossenen Schaltzustand befindet, erfasst die Messanordnung MA gemäß einem weiteren Verfahrensschritt S400 und in der gleichen Weise an der Batteriezelle Z1 eine zweite digitale Messspannung Um2.

Anschließend bildet die Messanordnung MA gemäß einem weiteren Verfahrensschritt S500 eine Spannungsdifferenz Ud zwischen der ersten und der zweiten Messspannung Um1, Um2 und leitet die Spannungsdifferenz Ud an die nachgeschaltete Vergleichseinheit VG weiter.

Die Vergleichseinheit VG überprüft gemäß einem weiteren Verfahrensschritt S600, ob die Spannungsdifferenz Ud in einem vorgegebenen Spannungstoleranzbereich Ub liegt. Hierzu vergleicht die Vergleichseinheit VG die Spannungsdifferenz Ud mit den beiden Grenzwerten des Spannungstoleranzbereichs Ub.

Liegt die Spannungsdifferenz Ud außerhalb des vorgegebenen Spannungstoleranzbereichs Ub, so wird gemäß einem weiteren Verfahrensschritt S700 von einem möglichen Fehler in der Spannungsausgleichsschaltung SA, insb. in der Messanordnung MA, ausgegangen.

Zur weitergehenden Überprüfung, ob der mögliche Fehler durch eine abweichende Grenzfrequenz von einem der beiden Filter FT1, FT2 verursacht wird, werden weitere Messspannungen gemessen, während der Ausgleichsschalter T1 geschlossen, und jeweils einer der beiden Überbrückungsschalter T2, T3 oder die beiden Überbrückungsschalter T2 und T3 geöffnet sind.

Aus den so gemessenen weiteren Messspannungen und der ersten Messspannung Um1 werden weitere Spannungsdifferenzen gebildet und überprüft, ob diese weiteren Spannungsdifferenzen in dem oben genannten Spannungstoleranzbereich Ub liegen. Ist es der Fall, so liegt die Quelle des oben erfassten Fehlers möglicherweise in dem Filter FT1 oder FT2, dessen Überbrückungsschalter T2 bzw. T3 während der Messung der entsprechenden weiteren Messspannung geöffnet war. Befinden sich diese weiteren Spannungsdifferenzen dagegen in dem genannten Spannungstoleranzbereich Ub, so liegt der Fehler in der Spannungsausgleichsschaltung SA bzw. in der Messanordnung MA.

## Patentansprüche

1. Batteriesystem (BS), umfassend:
- eine oder mindestens zwei in Reihe geschaltete Batteriezellen (Z0, Z1, Z2) und mindestens eine Spannungsausgleichsschaltung (SA) zum Ausgleichen der Spannung (Uz1) an der einen oder einer der mindestens zwei in Reihe geschalteten Batteriezellen (Z1);
- wobei die mindestens eine Spannungsausgleichsschaltung (SA) einen Ausgleichsstrompfad (SP) und eine Messanordnung (MA) umfasst;
- wobei der Ausgleichsstrompfad (SP) zwischen einem positiven Stromanschluss (PA) und einem negativen Stromanschluss (NA) der einen oder der einen der mindestens zwei Batteriezellen (Z1) elektrisch angeschlossen ist und zwei Widerstände (R1, R2) und einen steuerbaren Ausgleichsschalter (T1) umfasst, wobei die beiden Widerstände (R1, R2) und der Ausgleichsschalter (T1) zueinander in Reihe geschaltet sind; und
- die Messanordnung (MA) signaleingangsseitig an einem elektrischen Verbindungspunkt (VP) zwischen den beiden Widerständen (R1, R2) elektrisch angeschlossen ist und eingerichtet ist, ein erstes Spannungspotential (Φ1) an dem elektrischen Verbindungspunkt (VP) zu erfassen,
**dadurch gekennzeichnet, dass** die Messanordnung (MA) ferner aufweist:
- einen Analog-Digital-Wandler (AD), der über einen ersten Signaleingang (E1) mit dem elektrischen Verbindungspunkt (VP) elektrisch verbunden ist und eingerichtet ist, aus dem ersten Spannungspotential (Φ1) einen ersten digitalen Spannungspotentialwert zu bilden;
- einen Filter (FT1), der zwischen dem elektrischen Verbindungspunkt (VP) und dem Analog-Digital-Wandler (AD) elektrisch angeschlossen ist und eingerichtet ist, Wechselpotentialanteile in dem ersten Spannungspotential (Φ1) zu unterdrücken; und
- einen steuerbaren Überbrückungsschalter (T2), der zwischen dem elektrischen Verbindungspunkt (VP) und dem Analog-Digital-Wandler (AD) und parallel zu dem Filter (FT1) elektrisch angeschlossen ist und eingerichtet ist, in einem geschlossenen Schaltzustand den Filter (FT1) zu überbrücken.

2. Batteriesystem (BS) nach Anspruch 1, wobei die Messanordnung (MA) signaleingangsseitig ferner mit dem negativen Stromanschluss (NA) der einen oder der einen der mindestens zwei Batteriezellen (Z1) elektrisch verbunden ist und ferner eingerichtet ist, ein zweites Spannungspotential (Φ2) an dem negativen Stromanschluss (NA) zu erfassen.

3. Batteriesystem (BS) nach Anspruch 1 oder 2, wobei der Analog-Digital-Wandler (AD) über einen zweiten Signaleingang (E2) mit dem negativen Stromanschluss (NA) der einen oder der einen der mindestens zwei Batteriezellen (Z1) elektrisch verbunden ist und ferner eingerichtet ist, aus dem zweiten Spannungspotential (Φ2) einen zweiten digitalen Spannungspotentialwert zu bilden und aus dem ersten und dem zweiten digitalen Spannungspotentialwert die Messspannung auszubilden.

4. Elektrische Antriebsanordnung (EA), umfassend:
- eine elektrische Maschine (EM) zum elektrischen Antrieb;
- eine Leistungsendstufe (LE) zum Betreiben der elektrischen Maschine (EM);
- ein Batteriesystem (BS) nach einem der Ansprüche 1 bis 3 zum Bereitstellen elektrischer Energie für die elektrische Maschine (EM);
- wobei das Batteriesystem (BS) über elektrische Anschlüsse (A1, A2) mit der Leistungsendstufe (LE) und ferner über die Leistungsendstufe (LE) mit der elektrischen Maschine (EM) elektrisch verbunden ist.

## Claims

1. Battery system (BS), comprising:
- one or at least two battery cells (Z0, Z1, Z2) connected in series and at least one voltage balancing circuit (SA) for balancing the voltage (Uz1) at the one or at one of the at least two battery cells (Z1) connected in series;
- wherein the at least one voltage balancing circuit (SA) comprises a balancing current path (SP) and a measuring arrangement (MA);
- wherein the balancing current path (SP) is electrically connected between a positive power connection terminal (PA) and a negative power connection terminal (NA) of the one or of one of the at least two battery cells (Z1) and comprises two resistors (R1, R2) and a controllable balancing switch (T1), wherein the two resistors (R1, R2) and the balancing switch (T1) are connected in series with one another; and
- the measuring arrangement (MA) is electrically connected on the signal-input side to an electrical connecting point (VP) between the two resistors (R1, R2) and is configured to detect a first voltage potential (Φ1) at the electrical connecting point (VP),
**characterized in that** the measuring arrangement (MA) also has:
- an analog-to-digital converter (AD), which is electrically connected to the electrical connecting point (VP) by means of a first signal input (E1) and is configured to form a first digital voltage potential value from the first voltage potential (Φ1) ;
- a filter (FT1), which is electrically connected between the electrical connecting point (VP) and the analog-to-digital converter (AD) and is configured to suppress AC potential components in the first voltage potential (Φ1); and
- a controllable bypass switch (T2), which is electrically connected between the electrical connecting point (VP) and the analog-to-digital converter (AD) and in parallel with the filter (FT1) and is configured to bypass the filter (FT1) in a closed switching state.

2. Battery system (BS) according to Claim 1, wherein the measuring arrangement (MA) is also electrically connected on the signal-input side to the negative power connection terminal (NA) of the one or of one of the at least two battery cells (Z1) and is also configured to detect a second voltage potential (Φ2) at the negative power connection terminal (NA).

3. Battery system (BS2) according to Claim 1 or 2, wherein the analog-to-digital converter (AD) is electrically connected to the negative power connection terminal (NA) of the one or of one of the at least two battery cells (Z1) by means of a second signal input (E2) and is also configured to form a second digital voltage potential value from the second voltage potential (Φ2) and to form the measurement voltage from the first and the second digital voltage potential value.

4. Electrical drive arrangement (EA), comprising:
- an electric machine (EM) for electrical driving;
- a power output stage (LE) for operating the electric machine (EM);
- a battery system (BS) according to one of Claims 1 to 3 for providing electrical energy for the electric machine (EM);
wherein the battery system (BS) is electrically connected to the power output stage (LE) by means of electrical connection terminals (A1, A2) and also to the electric machine (EM) by means of the power output stage (LE).

## Revendications

1. Système de batteries (BS), comprenant :
- un ou au moins deux éléments de batterie montés en série (Z0, Z1, Z2) et au moins un circuit de compensation de tension (SA) pour compenser la tension (Uz1) au niveau dudit un ou de l'un desdits au moins deux éléments de batterie (Z1) montés en série ;
- dans lequel ledit au moins un circuit de compensation de tension (SA) comprend un trajet de courant de compensation (SP) et un dispositif de mesure (MA) ;
- dans lequel le trajet de courant de compensation (SP) est raccordé électriquement entre une borne de courant positive (PA) et une borne de courant négative (NA) dudit un ou de l'un desdits au moins deux éléments de batterie (Z1) et comprend deux résistances (R1, R2) et un commutateur de compensation pouvant être commandé (T1), dans lequel les deux résistances (R1, R2) et le commutateur de compensation (T1) sont montés en série l'un par rapport à l'autre ; et
- le dispositif de mesure (MA) est raccordé électriquement du côté de l'entrée de signal à un point de connexion électrique (VP) entre les deux résistances (R1, R2) et est conçu pour détecter un premier potentiel de tension (φ1) au niveau du point de connexion électrique (VP),
**caractérisé en ce que** le dispositif de mesure (MA) comprend en outre :
- un convertisseur analogique-numérique (AD) qui est relié électriquement au point de connexion électrique (VP) par l'intermédiaire d'une première entrée de signal (E1) et est conçu pour générer une première valeur numérique de potentiel de tension à partir du premier potentiel de tension (φ1) ;
- un filtre (FT1) qui est raccordé électriquement entre le point de connexion électrique (VP) et le convertisseur analogique-numérique (AD) et est conçu pour supprimer les composantes de potentiel alternatif du premier potentiel de tension (φ1) ; et
- un commutateur de pontage pouvant être commandé (T2) qui est raccordé électriquement entre le point de connexion électrique (VP) et le convertisseur analogique-numérique (AD) et en parallèle avec le filtre (FT1) et est conçu pour contourner le filtre (FT1) dans un état de commutation fermé.

2. Système de batteries (BS) selon la revendication 1, dans lequel le dispositif de mesure (MA) est en outre raccordé électriquement du côté de l'entrée de signal à la borne de courant négative (NA) dudit un ou de l'un desdits au moins deux éléments (Z1) et est en outre conçu pour détecter un deuxième potentiel de tension (Φ2) au niveau de la borne de courant négative (NA).

3. Système de batteries (BS) selon la revendication 1 ou 2, dans lequel le convertisseur analogique-numérique (AD) est relié électriquement par l'intermédiaire d'une deuxième entrée de signal (E2) à la borne négative (NA) dudit un ou de l'un desdits au moins deux éléments de batterie (Z1) et est en outre conçu pour générer une seconde valeur de potentiel de tension numérique à partir du second potentiel de tension (Φ2) et pour déterminer la tension de mesure à partir des première et seconde valeurs de potentiel de tension numériques.

4. Ensemble d'entraînement électrique (EA) comprenant :
- une machine électrique (EM) pour l'entraînement électrique ;
- un étage de sortie de puissance (LE) pour faire fonctionner ladite machine électrique (EM) ;
- un système de batteries (BS) selon l'une des revendications 1 à 3 pour l'alimentation en énergie électrique de la machine électrique (EM) ;
- dans lequel le système de batteries (BS) est relié électriquement à l'étage de sortie de puissance (LE) par l'intermédiaire de bornes électriques (A1, A2) ainsi qu'à la machine électrique (EM) par l'intermédiaire de l'étage de sortie de puissance (LE).
